# EUROPEAN PATENT APPLICATION

(11) **EP 1 363 142 A1**
(43) Date of publication of application: **19.11.2003**
(21) Application number: 01271550.4
(22) Date of filing: 18.12.2001
(51) Int. Cl.: G02B 1/10, H01L 31/04, G09F 9/00, H01J 29/88

(54) **REFLECTION REDUCING COATING, BASE MATERIAL AND PHOTOELECTRIC TRANSDUCER WITH THE REFLECTION REDUCING COATING**

(30) Priority: 19.12.2000 JP 2000385093
(71) Applicant: Nippon Sheet Glass Co., Ltd., Osaka-shi, Osaka 541-8559 (JP); KANEKA CORPORATION, Osaka-shi, Osaka 530-8288 (JP)
(72) Inventor: SETO, Yasunori, NIPPON SHEET GLASS CO., LTD., Osaka-shi, Osaka 541-8559 (JP); TSUJINO, Toshifumi, NIPPON SHEET GLASS CO., LTD., Osaka-shi, Osaka 541-8559 (JP); KINUGAWA, Katsuhiko, NIPPON SHEET GLASS CO., LTD., Osaka-shi, Osaka 541-8559 (JP); HIRATA, Masahiro, NIPPON SHEET GLASS CO., LTD., Osaka-shi, Osaka 541-8559 (JP)
(74) Representative: Power, Philippa Louise
(86) International application number: JP0111111
(87) International publication number: WO02050577

(57) **Abstract**

A reflection reducing coating allowing a durability represented by wear resistance to be compatible with a reflection reducing function, comprising a binder layer and a plurality of particulates, wherein the inside porosity of the binder layer is 50 volume% or less and the averaged value of the depths of the particulates buried in the binder layer is equivalent to 1/4 to 1/2 of the averaged particulate diameter of the plurality of particulates.

## Description

### Technical Field

The present invention relates to an antireflection film used for a vehicular glass, a showroom window, eyeglasses, an optical member such as a camera lens, or an information display such as a cathode ray tube. Further, the present invention relates to a substrate of glass, ceramic or the like having this antireflection film, and a photoelectric conversion device using them, for example, a solar cell panel.

### Background Art

For the purpose of improving functions in its use, a substrate of glass, ceramic or the like sometimes has a surface on which an antireflection film is formed so as to transmit more light or prevent glare caused by reflection. As such an antireflection film, a film that utilizes the difference in a refractive index with respect to the substrate to reduce reflectance is known. For example, JP 7(1995)-150356 A discloses a porous optical thin film obtained by removing only SiO₂ by gas plasma etching from a thin film formed of MgF₂ and SiO₂. Due to this porousness, an apparent refractive index of the film lowers. JP 9(1997)-249411 A discloses an antireflection film that is formed of silicon alkoxide and a dispersion of fine silica (SiO₂) powder such that most of the fine powder is embedded in a silica binder.

Substrates having such an antireflection film are used for vehicular glass, showrcom windows, photoelectric conversion devices or the like. In a thin film solar cell, which is one type of the photoelectric conversion devices, the antireflection film sometimes is formed on a principal surface that is opposite to a principal surface of a glass plate on which an undercoating film, a transparent conductive film, a photoelectric conversion layer formed of amorphous silicon or the like and a thin-film back electrode are layered in this order. In another solar cell using a bulk material of crystalline silicon as a photoelectric conversion element, a cover glass is disposed on an incident side of solar light, and the antireflection film sometimes is formed on the surface of this cover glass. When the antireflection film is formed on the incident side, more solar light is directed to the photoelectric conversion element, which can increase electric power generation. Not only the solar cells but also many other substrates having antireflection films are left standing outdoors for a long time and are difficult to replace once they are installed. Accordingly, the antireflection films need to have a high durability.

However, the optical thin film described in JP 7(1995)-150356 A does not have a sufficient durability because pores are formed in the entire film. This optical thin film is not designed for improving durability such as abrasion resistance but developed for improving laser damage resistance. Although the antireflection film described in JP 9(1997)-249411 A has a high durability, it cannot reduce the reflectance sufficiently.

### Disclosure of Invention

An antireflection film of the present invention includes a binder layer, and fine particles. The binder layer has an internal porosity of not greater than 50 vol%, and an average depth that the fine particles are embedded in the binder layer is 1/4 to 1/2 of an average particle diameter of the fine particles.

The present invention provides a substrate with an antireflection film including the above-described antireflection film and a substrate on which this antireflection film is formed. Further, the present invention provides a photoelectric conversion device including the above-described substrate with an antireflection film and a photoelectric conversion element, in which the substrate with an antireflection. film is disposed such that light entering this photoelectric conversion element passes through the antireflection film.

In accordance with the antireflection film of the present invention, it is possible to achieve both an excellent abrasion resistance and a reduction of reflectance. The durability of this antireflection film is sufficient to achieve a difference between reflectances before and after Taber's abrasion test, for example, within a visible light range of not greater than 1.5%. The Taber's abrasion test is a test according to JIS (the Japanese Industrial Standards) R3221 in which a rotating wheel is brought into contact with an antireflection film at 4.9 N. On the other hand, this antireflection film preferably can provide an antireflection effect sufficient for suppressing the visible light reflectance of the substrate with an antireflection film down to 3.5% or lower even after the above-mentioned Taber's abrasion test.

### Brief Description of Drawings

FIG. 1 shows a cross-section of an exemplary photoelectric conversion device using an antireflection film of the present invention.
FIG. 2 shows an antireflection film of Example 1 observed with a scanning electron microscope (SEM).
FIG. 3 shows an antireflection film of Comparative example 1 observed with the SEM.
FIG. 4 shows an antireflection film of Comparative example 2 observed with the SEM.
FIG. 5 shows an antireflection film of Comparative example 3 observed with the SEM.

### Embodiments of the Invention

The following is a description of an embodiment of the present invention. It should be noted that the present invention is by no means limited to the following embodiment.

In an antireflection film of the present invention, about 1/4 to 1/2 of each of fine particles is embedded and fixed into a binder layer. Accordingly, spaces are formed between the fine particles, making it possible to obtain an antireflection effect owing to a decrease in an apparent refractive index. In addition, suitable pores, for example, air bubbles in the binder layer, further lower the apparent refractive index of the antireflection film.

In the antireflection film of the present invention, since a part of each fine particle is embedded in the binder layer, the integrity of the antireflection film is enhanced suitably, thus achieving an improved physical durability. The fine particle surfaces that are not embedded in the binder layer form roughness on the surface of the antireflection film according to a particle diameter of the fine particles. Since this fine roughness scatters incident light, a so-called light trapping effect is obtained when this antireflection film is used in the photoelectric conversion device.

Here, the fine particles will be described. Although there is no particular limitation on the kind of the fine particles, fine particles containing silicon dioxide (SiO₂) as a main component, namely, fine silica particles are preferable. Because of its relatively low refractive index of about 1.4, the fine silica particles can contribute to the antireflection effect owing to a decrease in the refractive index and is preferable also in terms of its high chemical durability and ease of manufacturing. The fine silica particles can be, for example, those synthesized by allowing silicon alkoxide to react in the presence of a basic catalyst such as ammonia by a sol-gel process, colloidal silica made of sodium silicate, or fumed silica synthesized in a vapor phase. The fine silica particles may contain a minor component other than silica, for example, an oxide of aluminum, titanium, zirconium or tantalum.

Although there is no particular limitation on the shape of the fine particles, the fine particles can have a spherical shape, a rugby-ball shape or a shape according to various crystals. Total reflections are unlikely to occur on the spherical fine particles with no flat surfaces, and those particles have excellent abrasion resistance because of their small contact areas with an external material. Thus, when the abrasion resistance is given the first priority in the antireflection film, it is preferable that the fine particles have a substantially spherical shape.

The particle diameter of the fine particles is not limited specifically, but the average particle diameter preferably is at least 10 nm, further preferably at least 20 nm. When the average particle diameter is smaller than 10 nm, the fine particles are filled without any space therebetween, so that the apparent refractive index of the antireflection film does not lower sufficiently. On the other hand, an excessively large average particle diameter lowers adhesion between the fine particles and the substrate, so that the abrasion resistance of the antireflection film tends to become insufficient. Therefore, it is preferable that the average particle diameter of the fine particles is not greater than 1000 nm. Incidentally, the above-mentioned average particle diameter is not that of secondary particles of flocculated fine particles but that of primary particles.

The average particle diameter of the fine particles is measured based on a photograph taken using a SEM. The specific measurement method is as follows. An arbitrary place of a measurement sample is photographed under a magnification of 50000 times. A frame of 30 mm x 30 mm is drawn at a place where the fine particles are shown most clearly, and the maximum diameter of each of the fine particles (primary particles) within this frame is measured using a scale. Among the particles lying on a frame border, only the particles at least a half of whose area lies inside the frame are measured. Finally, the maximum diameters of all the measured fine particles are averaged so as to obtain the average particle diameter of the fine particles.

Next, the binder layer will be described. The binder layer lies between the fine particle and the substrate and between the fine particles and fixes the fine particles. Internal pores of the binder layer lower the apparent refractive index of the film so as to contribute to an improvement in the antireflection effect. The binder layer is not limited specifically but preferably contains at least one selected from the group consisting of a silicon oxide, an aluminum oxide, a titanium oxide, a zirconium oxide and a tantalum oxide as a main component. In the present description, the main component refers to a component accounting for at least 50 wt%. When a plurality of components serve as the main component, it is appropriate that the total of these components accounts for at least 50 wt%. The material for the metal oxides can be alkoxide containing the above-noted metallic elements such as silicon. The binder layer containing the above-noted metal oxides as a main component has a high physical strength, a high chemical stability, an excellent abrasion resistance and an excellent weather resistance. The binder layer formed of silicon alkoxide, more specifically silicon tetraalkoxide or an oligomer thereof has a low refractive index and is suitable for being formed to be relatively thick.

The binder layer, may be formed of a metal compound other than alkoxide. For example, the material thereof may be a metal halide or a metal compound having an isocyanate group, an acyloxy group or an aminoxy group. When hydrolyzed, these materials generate a component represented by a formula: M(OH)ₙ (M is a metal atom, and n is a natural number set according to a valence of the metal atom). In general, any material can be used as the material of the binder layer as long as it generates a component represented by the above general formula on hydrolysis.

When a compound represented by a formula: R¹ₘM(OR²)ₙ-ₘ (M and n are the same as above, R¹ is an organic group such as an alkyl group, R² is an organic group, mostly, an alkyl group, and *m* is a natural number from 1 to (n - 1)), which is one type of alkoxide, is used as the material, an organic residue remains on the surface of the binder layer. Since this organic residue forms micropores on the order of nanometers, the contamination removal characteristics of the antireflection film deteriorate over time owing to a capillary action of the micropores. Thus, it is appropriate that the material represented by the above formula is not greater than 50 wt% of a total material (solids) of the binder layer in terms of metal oxide.

It is preferable that the average depth of a portion of each fine particle embedded in the binder layer is 1/2 to 1/4 of the average particle diameter of the fine particles. When this depth is smaller than 1/4 of the average particle diameter, a contact area of the fine particles and the binder layer is too small to improve the abrasion resistance of the antireflection film sufficiently. On the other hand, when the depth exceeds 1/2, only tips of the fine particles protrude from the binder layer, so that the apparent refractive index of the antireflection film does not lower sufficiently. This is because spaces between the fine particles are filled with the binder layer.

The average depth of the embedded portions can be measured based on an SEM photograph taken under a magnification equal to the case of measuring the average diameter of the fine particles. Here, an arbitrary fracture plane is photographed, and the maximum depth of the portion of each particle embedded in the binder is measured with respect to the fine particles, for as many as those for measuring the average particle diameter. Then, these maximum depths are averaged.

The internal porosity of the binder layer is not greater than 50 vol%, preferably is not greater than 20 vol%, and more preferably is not greater than 10 vol%. When it exceeds 50 vol%, the strength of the binder layer drops, so that the abrasion resistance tends to become insufficient. On the other hand, in order to lower the apparent refractive index of the antireflection film, this internal porosity preferably is at least 5 vol%.

The internal porosity of the binder layer also is measured based on the photograph taken using the SEM. An arbitrary fracture plane of the measurement sample is photographed under a 50000x magnification. On this photograph, a frame is set at a portion of the binder layer where the pores are. shown most clearly, and the areas of the pores within this frame are measured using a scale. Such a measurement is carried out at ten or more locations. In the case where it is difficult to find ten or more suitable measurement locations on one SEM photograph, different SEM photographs can be used as long as the subject samples thereof are the same. Then, the area of all the measured pores is divided by the total area of the frame (binder layer alone) so as to obtain the porosity.

In other words, (the internal porosity of the binder layer) = (the area of all the pores) / (the total area within the frame). The total area within the frame is an area of the binder layer alone except the fine particles.

There is no particular limitation on the kinds of the substrate. Any substrate can be used as long as it has been used conventionally for an application requiring an antireflection function. An example of the substrate includes glass, resin, ceramics and manufactured products thereof.

The following is a description of a method for forming the antireflection film. Although the antireflection film may be formed using any method that has been conventionally known as a method for forming thin films, it is preferable to employ a method of applying a solution containing a material of the antireflection film (hereinafter, referred to as a "coating solution") onto a substrate surface, and then heating the entire substrate. A dehydration condensation reaction proceeds by heating so as to form an original form of the binder layer, and at the same time, volatile components such as a solvent and reaction-product water vaporize. Then, further heating allows organic components such as an alkyl group to burn, so that pores are formed inside the binder layer. In other words, by a heating process, the formation of the binder layer, the formation of the internal pores and the fixing of the fine particles proceed simultaneously. When the above-mentioned metal compound is used as the material of this binder layer, the substrate and the fine particles are fixed firmly to each other, thereby achieving an antireflection film having extremely high physical and chemical durabilities.

The substrate onto which the coating solution is applied is heated, thereby enhancing the adhesion between the fine silica particles, binder and substrate. The highest heating temperature is preferably at least 200°C, more preferably at least 400°C, and particularly preferably at least 600°C. When the substrate is heated to at least 200°C, the coating solution turns into a gel reliably so as to become adhesive. At 400°C or higher, the organic components remaining in the antireflection film are almost completely burned and lost. At 600°C or higher, a condensation reaction of a remaining unreacted silanol group and a hydrolytic group in a hydrolysate of a metal compound substantially ends so as to densify the film, thus improving the film strength. The heating period preferably is 5 seconds to 5 hours, more preferably 30 seconds to 1 hour. On the other hand, the heating temperature realistically is not higher than 800°C in view of heat resistance of the substrate and cost effectiveness of the heating treatment.

The method for applying the coating solution to the substrate is not particularly limited but can be a method using a spin coater, a roller coater, a spray coater or a curtain coater, a method such as immersion coating (dip coating) or flow coating, or various printing methods such as flexography, screen printing, gravure printing or curved-surface printing.

There are some cases where the coating solution does not wet the substrate surface easily and cannot be applied uniformly depending on the condition of the substrate surface. In such cases, it is appropriate to clean or reform the substrate surface. The method for cleaning or reforming can be degrease-cleaning by an organic solvent such as alcohol, acetone or hexane, cleaning by alkali or acid, surface grinding with abrasives, ultrasonic cleaning, an ultraviolet irradiation, an ultraviolet ozone treatment or a plasma treatment.

It is preferable that the coating solution is prepared by mixing the fine particles with a hydrolysable metal compound, a catalyst for hydrolysis, water and a solvent so as to hydrolyze the metal compound. The hydrolysis is promoted by stirring for at least 1 hour at room temperature, or for 10 to 50 minutes at a temperature higher than the room temperature, for example, 40°C to 80°C.

As the catalyst for hydrolysis, an acid catalyst, for example, an acetic acid or a mineral acid such as a hydrochloric acid or a nitric acid is preferable. The use of the acid catalyst promotes the hydrolysis of the metal alkoxide, producing more M(OH)ₙ. Thus, the bonding of the metal oxide is densified, in other words, strengthened. On the other hand, the use of a basic catalyst inhibits the hydrolysis, accelerating the condensation reaction. Accordingly, the reaction product of the metal alkoxide is consumed for generating fine particles and growing the particles. As a result, it becomes difficult to achieve a function of fixing the fine particles, which is an original function of the binder layer.

The blend ratio by weight of the catalyst in the coating solution preferably is 0.0006 to 2.4 in terms of metal compound.

When a hydrolysis component is contained in the coating solution, the solution has to contain water. The water content by weight in the coating solution preferably is 0.02 to 20 in terms of metal compound. When the value is smaller than 0.1, the hydrolysis of the metal compound is not promoted sufficiently. On the other hand, the value over 100 reduces the stability of the coating solution.

When a compound containing a chloro group is used as the metal compound, it is essentially unnecessary to add water and a catalyst. This is because the hydrolysis proceeds by water contained slightly in the solvent and water in the atmosphere. With this hydrolysis, a hydrochloric acid is liberated into the coating solution, thus promoting the hydrolysis further.

The solvent is not specifically limited as long as it can dissolve the metal compound. An example thereof includes alcohols such as methanol, ethanol, propanol, butanol and diacetone alcohol, cellosolves such as ethyl cellosolve, butyl cellosolve and propyl cellosolve, and glycols such as ethylene glycol, hexylene glycol and propylene glycol.

When the metal compound concentration in the coating solution is too high, the spaces between the fine particles decrease in the antireflection film, so that it becomes difficult to lower its apparent refractive index. Thus, the metal compound concentration in the coating solution preferably is not greater than 20 wt%, and more preferably is 1 wt% to 20 wt%.

It is preferable that the ratio by weight of the fine particles to the metal compound in the coating solution is in the range of fine particles : metal oxide = 50 : 50 to 99 : 1 when converting the metal compound into the metal oxide (SiO₂ or the like). In the case where the coating solution is prepared by hydrolyzing the metal compound in the presence of fine silica particles, the ratio preferably is fine silica particles : metal oxide = 66 : 34 to 95 : 5, more preferably is 75 : 25 to 90 : 10 (by weight). On the other hand, in the case where the metal compound is hydrolyzed in the absence of the fine particles, the ratio preferably is fine particles : metal oxide = 50 : 50 to 85 : 15, more preferably is 60 : 40 to 75 : 25 (by weight).

Table 1 below shows a preferred blend ratio of the coating solution.

**(Table 1)**

| | |
|---|---|
| Hydrolysable metal compound (in terms of metal oxide) | 100 weight parts |
| Fine silica particles with an average primary particle diameter of 10 to 500 nm | 100 to 9900 weight parts |
| Water | 50 to 10000 weight parts |
| Acid catalyst | 0.01 to 200 weight parts |
| Solvent | 1000 to 500000 weight parts |

When using such a substrate with an antireflection film in a photoelectric conversion device, it is preferable that a glass plate is used as the substrate. This glass plate is disposed such that the antireflection film faces the light incident side, and its low reflection properties can direct more light to a photoelectric conversion element such as a photoelectric conversion layer. Furthermore, since light is scattered on the surface of the antireflection film (the surfaces of the fine particles), a so-called light trapping effect of extending an optical path in the photoelectric conversion element can be achieved. When the glass plate is used in the photoelectric conversion device, the surface thereof (the surface on which the antireflection film is formed) preferably has a reflectance of not greater than 3.5%, further preferably not greater than 3.0%, and particularly preferably lower than 2.0% except the backside reflection.

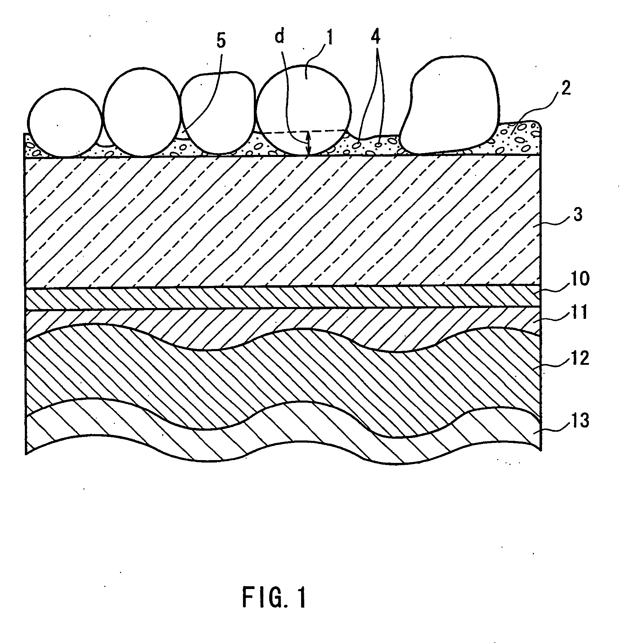

This substrate having an antireflection film can be used in a solar cell whose photoelectric conversion element is formed either of a thin film or a bulk crystal. In either case, a similar antireflection effect and light trapping effect can be achieved. The method for manufacturing the photoelectric conversion device is not particularly limited. As long as the antireflection film is formed by the above-described method, the other parts can be manufactured by a known method. For example, in the case of a solar cell having a photoelectric conversion element of an amorphous silicon thin film, as shown in FIG. 1, an undercoating film 10 and a transparent conductive film 11 are formed first on one principal surface of a glass plate 3, and then an antireflection film can be formed on the opposite surface by the above-described method. The undercoating film 10, the transparent conductive film 11, a photoelectric conversion layer 12 formed of amorphous silicon and a thin-film back electrode 13 all may be formed by a chemical vapor deposition method (CVD method), for example.

As shown in FIG. 1, an antireflection film including fine particles 1 and a binder layer 2 has a lowered apparent refractive index owing to internal pores 4 in the binder layer and spaces 5 between the fine particles. The depth of the fine particles embedded in the binder layer is illustrated by d in FIG. 1. When a line connecting the highest points of the binder layer at right and left edges of the fine particle is set as a reference line, this d is defined as the length of the longest normal line from this reference line toward an edge of the fine particle embedded in the binder layer.

### Examples

In the following, the present invention will be described more specifically by way of examples. The present invention is by no means limited to the following examples.

Antireflection films were formed on the surface of a glass plate by methods that will be described in the Examples and Comparative examples below, and the reflectance, haze ratio and abrasion resistance of each antireflection film were measured by the following methods.

### [Average Reflectance (Visible Light Reflectance)]

Light was made to enter the antireflection film from a normal direction using a spectrophotometer (UV-3100, manufactured by Shimadzu Corporation), and direct reflected light at a reflection angle of 8° was measured with an integrating sphere. Among the measurement data, reflection spectra of 400 to 800 nm were averaged, thus obtaining the reflectance of the antireflection film within the visible light range. In order to exclude the reflected light from the backside of the substrate (glass plate), the backside of the glass plate was subjected to sand-blasting and black spraying.

### [Haze Ratio]

By using an integrating-sphere light transmittance measuring apparatus (HGM-2DP, manufactured by Suga Test Instruments Co., Ltd.), measurement was conducted based on a haze value measuring method prescribed in JIS K7105-1981 (a method for testing optical properties of plastics).

### [Abrasion Resistance]

The abrasion resistance was evaluated according to Taber's abrasion test prescribed in JIS R3221. More specifically, after the rotating wheel of CS-10F was rotated 100 times while being pressed against the antireflection film at 4.9 N, the reflectance of the antireflection film was measured.

Further, the antireflection film was observed with an optical microscope after each of 50, 100, 300, 500, 700, 900 and 1000 rotations of the rotating wheel that is pressed against the antireflection film at 2.45 N. At each time, the amount of change in the haze ratio and the reflectance were measured as well. The haze ratio is an index of a light scattering state, and an increase in its value generally indicates that a scattering surface becomes rougher. Incidentally, the "amount of change in the haze ratio" equals "(the haze ratio (%) after Taber's abrasion test) - (the haze ratio (%) before Taber's abrasion test)".

### [Alkali Resistance]

The antireflection film was evaluated according to an alkali resistance test prescribed in JIS R3221. First, as an alkali solution, a 1 N sodium hydroxide solution at 23°C was prepared, in which a glass plate with an antireflection film was dipped for 24 hours. Then, after being washed in water and dried, the antireflection film was rubbed with a dry cloth so as to observe visually whether the antireflection film peeled off. The test result is indicated as follows.
No: the film did not peel off.
Partial: the film peeled off partially.
Yes: the film peeled off.

### (Example 1)

First, 46.67 g of dispersion of fine silica particles having an average primary particle diameter of 110 nm (aqueous solvent; 15% solids) was stirred sufficiently. Then, 41.93 g of ethyl cellosolve, 1 g of hydrochloric acid and 10.4 g of tetraethoxyorthosilane were added sequentially to the above dispersion, thus preparing 100 g of a solution A. A separately prepared solution B, which was a mixture of 40 g of propylene glycol and 10 g of diacetone alcohol, was added to 50 g of the solution A and stirred sufficiently, thus obtaining a coating solution. A catalyst in this coating solution was the hydrochloric acid, and its blend ratio by mole was 0.54 in terms of metal compound (tetraethoxyorthosilane). Although water was not added intentionally, it was contained in the dispersion of fine silica particles and the hydrochloric acid solution, and thus no problem was caused in hydrolyzing the metal compound. In the coating solution, the blend ratio of water by mole was 44 in terms of metal compound. Also, the ratio of the fine silica particles to the metal oxide was fine silica particles : tetraethoxyorthosilane (in terms of metal oxide) = 70 : 30.

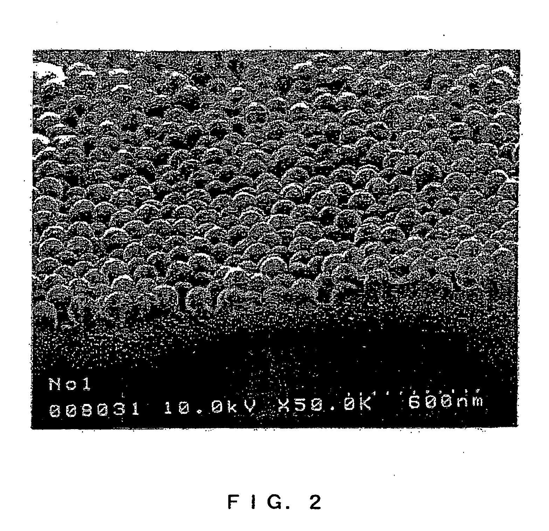

This coating solution was applied onto a 300 mm × 300 mm commercially available soda-lime glass plate with a thickness of 4 mm by flexography, and then the entire glass plate was allowed to stand in a heating furnace kept at 500°C for 2 hours. After the antireflection film was formed, it was photographed under a 50000× magnification using the SEM. As shown in FIG. 2, in this antireflection film, it was found that 1/2 of the average particle diameter of the fine silica particles was embedded in the binder layer and that the internal porosity of the binder layer was 40%.

Furthermore, the reflectance, haze ratio, abrasion resistance and alkali resistance of this antireflection film were measured by the above-described methods. Tables 2 to 4 show the results of the measurements. Even after 1000 rotations of the rotating wheel, this antireflection film maintained a sufficient antireflection performance required for a photoelectric conversion device.

Moreover, the performance of the glass plate with this antireflection film as a photoelectric conversion device was evaluated with a short circuit current. It is generally known that a photoelectric conversion efficiency rises with the short circuit current. The result of this short circuit current measurement is shown in Table 2 as a value relative to a measurement value in Comparative example 4.

### (Comparative example 1)

A solution a was prepared similarly to the solution A except that the blend amounts were changed to 56.67 g of the dispersion of fine silica particles, 37.13 g of ethyl cellosolve, 1 g of hydrochloric acid and 5.2 g of tetraethoxyorthosilane. Then, 40 g of the solution a was introduced in a solution b, which was a mixture of 40 g of hexylene glycol and 20 g of ethyl cellosolve, followed by sufficient stirring, thus preparing a coating solution.

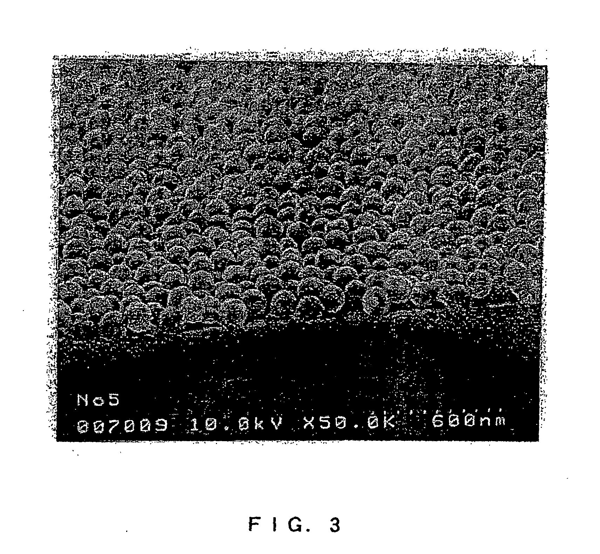

Using this coating solution, an antireflection film was produced similarly to Example 1 and measured similarly to Example 1. Tables 2 to 4 show the results of the measurements. FIG. 3 shows this antireflection film observed with the SEM.

From FIG. 3, in this antireflection film, it was found that 1/10 of the average particle diameter of the fine silica particles was embedded in the binder layer and that the internal porosity of the binder layer was 90%. Moreover, in the abrasion resistance test, the antireflection film peeled off completely at the time when the rotating wheel was rotated 100 times.

In addition, the short circuit current value was measured similarly to Example 1. The result is shown in Table 2 as a relative value.

### (Comparative example 2)

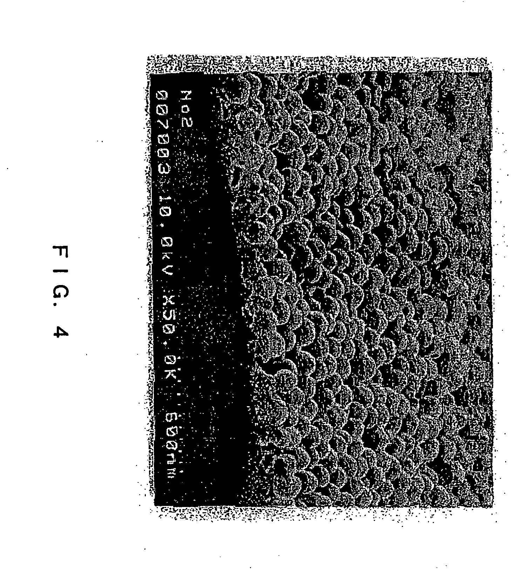

40 g of the solution A was added to the solution b and stirred sufficiently, thus preparing a coating solution. Using this coating solution, an antireflection film was produced similarly to Example 1 and measured similarly to Example 1. Tables 2 to 4 also show the results of these measurements. Further, FIG. 4 shows this antireflection film observed with the SEM.

From FIG. 4, in this antireflection film, it was found that 1/2 of the average particle diameter of the fine silica particles was embedded in the binder layer and that the internal porosity of the binder layer was 65%. In the abrasion resistance test, the antireflection film peeled off completely at the time when the rotating wheel was rotated 300 times.

### (Comparative example 3)

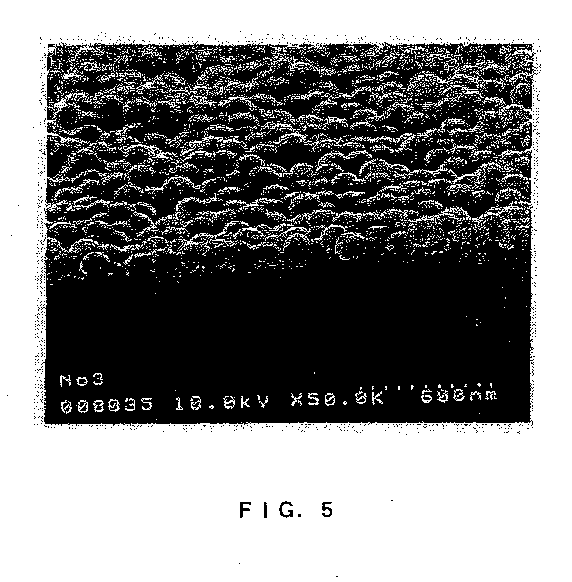

A solution a' was prepared similarly to the solution A except that the blend amounts were changed to 40.0 g of the dispersion of fine silica particles, 45.2 g of ethyl cellosolve, 1 g of hydrochloric acid and 13.8 g of tetraethoxyorthosilane. Then, 40 g of the solution a' was introduced in the solution b, followed by sufficient stirring, thus preparing a coating solution. Using this coating solution, an antireflection film was produced similarly to Example 1 and measured similarly to Example 1. Tables 2 and 4 show the results of the measurements. Further, FIG. 5 shows this antireflection film observed with the SEM.

From FIG. 5, in this antireflection film, it was found that 4/5 of the average particle diameter of the fine silica particles was embedded in the binder layer and that the internal porosity of the binder layer was 60%. Moreover, in the abrasion resistance test, the antireflection film peeled off completely at the time when the rotating wheel was rotated 300 times.

### (Comparative example 4)

The average reflectance of a float glass substrate similar to that in Example 1 was measured. Also, the short circuit current value thereof was measured similarly to Example 1 and Comparative example 1. The results are shown in Table 2. Comparative example 4 is directed to a transparent substrate with no antireflection film.

**(Table 2)**

| Item | Example 1 | Comp. ex. 1 | Comp. ex. 2 | Comp. ex. 3 | Comp. ex. 4 |
|---|---|---|---|---|---|
| Solids in coating solution (%) | 5 | 4 | 4 | 4.7 | - |
| Weight percentage of fine particles (%) | 70 | 85 | 70 | 60 | - |
| Embedded depth of fine particles | 1/2 | 1/10 | 1/2 | 4/5 | - |
| internal porosity (%) | 40 | 90 | 65 | 60 | - |
| Average reflectance (%) | 1.7 | 1.4 | 1.9 | 2.0 | 4.1 |
| Alkali resistance | No | Yes | Partial | Partial | - |
| Short circuit current relative value | 1.04 | 1.05 | - | - | 1.00 |

**(Table 3)**

| when rotating wheel was pressed against antireflection film at 4.9 N | | | |
|---|---|---|---|
| | Example 1 | Comp. ex. 1 | Comp. ex. 2 |
| Before Taber's test | 1.7 | 1.4 | 1.9 |
| After Taber's test | 2.7 | 3.9 | 3.8 |
| Difference between values before and after test | 1.0 | 2.5 | 1.9 |
| Reflectance (%) | | | |

**(Table 4)**

| when rotating wheel was pressed against antireflection film at 2.45 N | | | | |
|---|---|---|---|---|
| The number of rotations (n) | Example 1 | Comp. ex. 1 | Comp. ex. 2 | Comp. ex. 3 |
| 0 | 0/1.7 | 0/1.4 | 0/1.9 | 0/2.0 |
| 50 | 0.7/2.4 | 2.3/3.4 | 1.9/3.3 | 1.9/2.7 |
| 100 | 0.8/2.7 | Film peeled off | 2.9/3.6 | 1.9/2.9 |
| 300 | 1.3/2.8 | | Film peeled off | Film peeled off |
| 500 | 1.7/3.0 | | | |
| 700 | 1.7/3.0 | | | |
| 900 | 1.4/3.0 | | | |
| 1000 | 1.4/3.0 | | | |
| (Amount of change in haze ratio/reflectance (%)) | | | | |

From the comparison between Example 1 and Comparative example 2, it was found that, even when the fine particles were embedded suitably in the binder layer, the antireflection film became brittle and easier to peel off with an increase in the internal porosity of the binder layer.

From the comparison between Example 1 and Comparative example 1, it was found that, when the fine particles were embedded shallowly in the binder layer, the antireflection film achieved a lower reflectance owing to a decrease in its apparent refractive index caused by the formation of spaces between the fine particles but suffered from declining physical strength, resulting in easier peeling.

From the comparison between Example 1 and Comparative example 3, the following was found. When the fine particles were embedded deeply in the binder layer and only a part of each fine particle was exposed to a surface of the binder layer, the reflectance of the antireflection film slightly rises, and this state does not change very much even after increased rotations in the Taber's abrasion test. However, as the rotations in the Taber's abrasion test were increased further, the antireflection film suddenly peeled off. This indicated that too many internal pores in the binder layer lowered the strength (durability) of the binder layer.

Similarly, from the comparison between Example 1 and Comparative examples 1 to 3, it was found that, when the internal porosity of the binder layer exceeded 50 vol%, the alkali resistance of the antireflection film became insufficient. As described above, the antireflection film of Example 1 was excellent not only in its abrasion resistance but also in its chemical durability.

From the comparison between Example 1 and Comparative examples 1 and 4, it was found that the antireflection film raised the short circuit current value. This indicated that it was possible to enhance the photoelectric conversion efficiency of a solar cell by forming the antireflection film.

## Claims

1. An antireflection film comprising:
a binder layer; and
fine particles;
wherein the binder layer has an internal porosity of not greater than 50 vol%, and
an average depth that the fine particles are embedded in the binder layer is 1/4 to 1/2 of an average particle diameter of the fine particles.

2. The antireflection film according to claim 1, wherein in Taber's abrasion test according to JIS R3221 in which a rotating wheel is brought into contact with an antireflection film at 4.9 N, a difference between reflectances before and after the test within a visible light range is not greater than 1.5%.

3. The antireflection film according to claim 1, wherein the average particle diameter of the fine particles is 10 nm to 1000 nm.

4. The antireflection film according to claim 1, wherein the binder layer comprises as a main component at least one selected from the group consisting of a silicon oxide, an aluminum oxide, a titanium oxide, a zirconium oxide and a tantalum oxide.

5. The antireflection film according to claim 1, wherein the binder layer has an internal porosity of at least 5 vol%.

6. A substrate with an antireflection film, comprising:
the antireflection film according to claim 1; and
a substrate on which the antireflection film is formed.

7. The substrate with an antireflection film according to claim 6, wherein the substrate is a glass plate.

8. A photoelectric conversion device comprising:
the substrate with an antireflection film according to claim 6; and
a photoelectric conversion element;
wherein the substrate with an antireflection film is disposed such that light entering the photoelectric conversion element passes through the antireflection film.
